# EUROPEAN PATENT APPLICATION

(11) **EP 4 358 131 A1**
(43) Date of publication of application: **24.04.2024**
(21) Application number: 23204122.8
(22) Date of filing: 17.10.2023
(51) Int. Cl.: H01L 23/48

(54) **SEMICONDUCTOR DEVICE WITH STACKED CONDUCTIVE LAYERS AND RELATED METHODS**

(30) Priority: 18.10.2022 US 202263379993 P; 12.10.2023 US 202318485565
(71) Applicant: Semiconductor Components Industries, LLC, Scottsdale, AZ 85250 (US)
(72) Inventor: NOMA, Takashi, Ota, 3730815 (JP); ISHIBE, Shinzo, Oizumi-machi, 370-0535 (JP)
(74) Representative: Manitz Finsterwald Patent- und Rechtsanwaltspartnerschaft mbB

(57) **Abstract**

A device may include an insulating layer disposed on a frontside of a semiconductor layer, and may include a first conductive contact disposed in a first opening in the insulating layer. The device may include a second conductive contact disposed in a second opening in the insulating layer, and may include a stacked conductive layer disposed on the first conductive contact and excluded from the second conductive contact.

## Description

### RELATED APPLICATION

This application is related to U.S. Provisional Application Serial No. 63/379,993, filed on October 18, 2022, which is incorporated herein by reference in its entirety.

### FIELD

Aspects of this document relate generally to semiconductor wafer and device processing methods.

### BACKGROUND

Semiconductor fabrication processes may involve many steps. In some processes one or more semiconductor devices can be formed on a wafer. Electrically conductive layers may be used to provide electrical contact areas for individual semiconductor devices that are separated out from the wafer. Electrically conductive layers may include one or more back metal layers at a back side of the wafer and one or more over contact metallization layers at a top side of the wafer.

### SUMMARY

In some aspects, the techniques described herein relate to a method, including: forming an insulating layer on a frontside of a semiconductor layer; forming a first conductive contact in a first opening in the insulating layer; forming a second conductive contact in a second opening in the insulating layer; and selectively forming a stacked conductive layer on the first conductive contact without forming a portion of the stacked conductive layer on the second conductive contact.

In some aspects, the techniques described herein relate to an apparatus, including: an insulating layer disposed on a frontside of a semiconductor layer; a first conductive contact disposed in a first opening in the insulating layer; a second conductive contact disposed in a second opening in the insulating layer; and a stacked conductive layer disposed on the first conductive contact and excluded from the second conductive contact.

In some aspects, the techniques described herein relate to a method, including: forming an insulating layer on a frontside of a semiconductor layer; forming a first conductive contact in a first opening in the insulating layer; forming a second conductive contact in a second opening in the insulating layer; forming a first polyimide layer on the second conductive contact and the insulating layer; forming a second polyimide layer over the first polyimide layer; forming, in the second polyimide layer, a first opening above the first conductive contact and a second opening above the first polyimide layer to expose the first polyimide layer above the second conductive contact through the second opening; forming a stacked conductive layer over the first conductive contact; and forming a third opening in the first polyimide layer for the second conductive contact.

The details of one or more implementations are set forth in the accompanying drawings and the description below. Other features will be apparent from the description and drawings, and from the claims.

### BRIEF DESCRIPTION OF THE DRAWINGS

FIG. 1 illustrates a semiconductor device with a stacked conductive layer selectively formed over a first conductive contact, but not over a second conductive contact.
FIG. 2A illustrates a semiconductor device that is a variation of the semiconductor device shown in FIG. 1.
FIG. 2B illustrates the semiconductor device, shown in FIG. 2A, after a support ring formed by a grinding process has been removed.
FIGs. 3A and 3B illustrate a semiconductor wafer where the semiconductor devices shown in FIGs. 1 through 2B can be formed.
FIGs. 4A through 4K illustrate a method of manufacturing at least the semiconductor devices shown in FIGs. 1 through 3B.
FIG. 5 is a flowchart that illustrates a method of manufacturing at least the semiconductor devices shown in FIGs. 1 through 4K.
FIG. 6 is another flowchart that illustrates a method of manufacturing at least the semiconductor devices shown in FIGs. 1 through 4K.

### DETAILED DESCRIPTION

The implementations described herein are related to selectively forming and not forming a stacked conductive layer on conductive contacts (e.g., a metal contact) within a semiconductor device to prevent the possibility of undesirable alloy formation when, for example, later wire bonding is performed. For example, an undesirable alloy (e.g., an unreliable alloy interface) can be formed between a wire bond and the stacked conductive layer within a semiconductor device. This can result in an unreliable connection via the wire bond and the stacked conductive metal layer to the conductive contact of the semiconductor device. In other words, when a stacked conductive layer is applied to the electrically conductive areas (e.g., conductive contacts or conductive contact areas) of the semiconductor devices, to allow for outside electrical connection to the semiconductor devices, there may be connectivity issues via the stacked conductive layer (e.g., an intervening stacked conductive layer). The selective formation of the stacked conductive layer on conductive contacts, to prevent, for example, reliability issues, can be controlled using a variety of mask layers (e.g., polyimide (PI) layers). The selective formation of the stacked conductive layer on conductive contacts can include forming a portion of a stacked conductive layer on a first conductive contact without forming a portion of the stacked conductive layer on a second conductive contact (within a same layer within a stack within a semiconductor device). In some implementations the stacked conductive layer can be, for example, an Electroless Nickel Electroless Palladium Immersion Gold (ENEPIG) layer.

Some implementations described herein can be directed to, for example, forming a dual-sided stacked conductive layer (e.g., a dual-sided ENEPIG layer) over at least a first conductive contact without forming a portion of the stacked conductive layer on at least a second conductive contact. This can result in preventing formation of an undesirable alloy on the second conductive contact when wire bonding to the second conductive contact is performed. As another example, a dual-sided stacked conductive layer can be, for example, formed over an emitter conductive contact and a collector conductive contact (which can be on an opposite side of the collector) of a semiconductor device, without being formed on a gate conductive contact of the semiconductor device. This can ensure reliable wire bonding (e.g., wire bonding using aluminum) directly to the gate conductive contact (e.g., gate metal contact) and not on the stacked conductive layer because a stacked conductive layer is not formed on the gate conductive contact.

As a specific example, in an IGBT module, there may be connectivity issues as an aluminum (Al) wire is bonded on a stacked conductive layer. The ENEPIG layer can be a layer disposed between the wire bond and a conductive contact (e.g., a gate metal contact, a source metal contact).

The formation of an undesirable alloy, such as a gold-aluminum (AuAl) intermetallic, at an interface between an aluminum wire bonded to the ENEPIG layer (which is disposed between the aluminum wire bond and a conductive contact) can result in connectivity issues and/or in a reliability risk. The formation of the AuAl intermetallic can be at the interface between the two metals (wire bond metal and the ENEPIG layer). Preventing formation of an undesirable alloy can be particularly important in, for example, automotive applications.

The semiconductor devices may include a variety of devices such as insulated-gate bipolar transistors (IGBTs), diodes, power devices such as metal oxide semiconductor field effect transistors (MOSFETs), gallium nitride (GaN) devices, silicon carbide (SiC) devices, intelligent power modules (IPMs), processor and memory (PIM) devices, and/or so forth.

Some examples may be implemented using various types of semiconductor processing techniques associated with semiconductor substrates including, but not limited to, for example, Silicon (Si), Gallium Arsenide (GaAs), GaN, SiC and/or so forth.

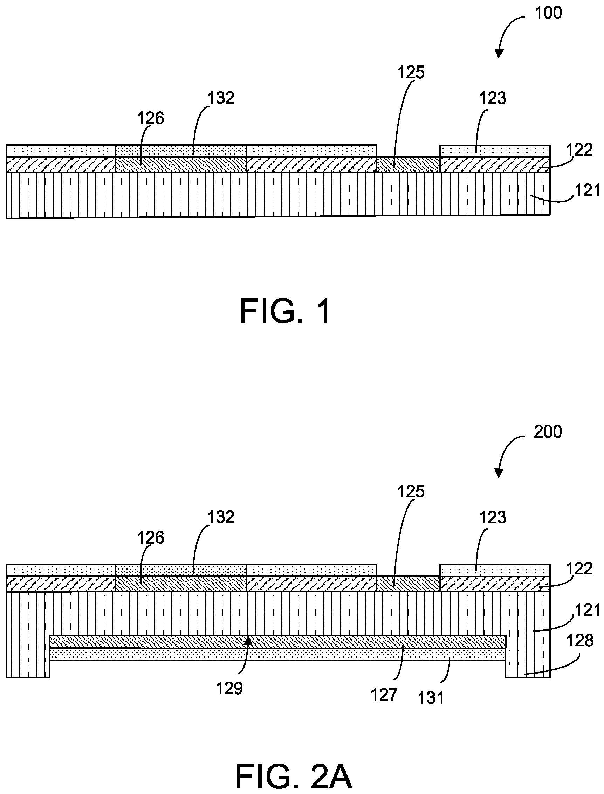

FIG. 1 illustrates a semiconductor device 100 with a stacked conductive layer 132 (also can be referred to as a frontside stacked conductive layer) that is selectively formed over a first conductive contact 126, but not over a second conductive contact 125. The first conductive contact 126, the second conductive contact 125, and an insulating layer 122 are disposed on a semiconductor layer 121 (also can be referred to as a semiconductor region). The first conductive contact 126 is isolated from the second conductive contact 125 by at least a portion of the insulating layer 122. The stacked conductive layer 132 is disposed within a same layer level (or within a same plane) as a polyimide layer 123. As shown in figure one, the second conductive contact 125 is exposed through an opening of the polyimide layer 123.

In some implementations the stacked conductive layer 132 can be, for example, an Electroless Nickel Electroless Palladium Immersion Gold (ENEPIG) layer (also can be Electroless Nickel / Electroless Palladium / Immersion Gold (ENEPIG)). In some examples, the ENEPIG may be formed by the deposition of electroless nickel, followed by electroless palladium, with an immersion gold flash.

In some implementations, the PI layer 123 may be excluded and/or replaced by some other insulating layer (e.g., electrically insulating layer). In some examples, the PI layer may be formed of a non-photosensitive polyimide such as, by non-limiting example, a polyimide. Any suitable insulative material(s) may be used for the electrically insulating layer(s), however, and this is only an example.

In some implementations, the use of the polyimide layer 123 can be particularly important because manufacturing steps used to form the stacked conductive layer 132 (e.g., relatively high temperature annealing of the stacked conductive layer 132) may adversely affect layers made of other materials. In other words, the polyimide layer 123 can be robust against conditions during formation of the stacked conductive layer 132, such as an ENEPIG layer.

As shown in FIG. 1, because the second conductive contact 125 is exposed through the PI layer 123, a metal, such as a wirebond, can be directly contacted with the second conductive contact 125. The metal can be directly contacted with the second conductive contact 125 without an intervening stacked conductive layer. Because a stacked conductive layer is excluded from the second conductive contact 125, a direct metal connection with the second conductive contact 125 can be more reliable. The direct metal connection with the second conductive contact 125 can be more reliable than if the electrical connection were made via a stacked conductive layer (e.g., a stacked conductive layer portion).

In this implementation, and in the implementations described herein, a topside of the semiconductor layer 121 (top of FIG. 1) is referred to as a frontside of the semiconductor device 100, and a bottom side of the semiconductor layer 121 (bottom of FIG. 1) is a backside of the semiconductor device 100.

The contacts, electrically insulating layers, and openings may be formed using any material deposition and removal techniques such as electro-plating, electroless plating, spinning, sputtering, evaporation, chemical vapor deposition (CVD), physical vapor deposition (PVD), etching, masking, photolithography techniques, and the like. In some implementations, a portion of the semiconductor layer 121 may be doped, and the dopants may be introduced by any doping technique such as ion implantation, deposition, and diffusion, and the like. One or more dopants such as boron, phosphorous, and so forth may be used (the dopant(s) may be selected depending on the semiconductor substrate such as Si, GaAs, GaN, SiC, and so forth).

The semiconductor device 100 may be, or may include, power devices such as MOSFETs, GaN devices, SiC devices, and IPMs, PIMs, diodes, fast recovery diodes (FRDs), and/or so forth.

FIG. 2A illustrates a semiconductor device 200 that is a variation of the semiconductor device 100 shown in FIG. 1. Elements that are described in FIG. 1 are not described again in FIG. 2A. As shown in FIG. 2A, the semiconductor device 200 has a back conductive contact 127. A stacked conductive layer 131 (also can be referred to as a backside stacked conductive layer) is coupled to the back conductive contact 127. Because the semiconductor device 200 has the stacked conductive layer 131, the stacked conductive layer 132 can be referred to as a frontside stacked conductive layer.

In this implementation, the semiconductor device 200 has a support ring 128 formed from the semiconductor layer 121. Accordingly, a recess 129 is defined within the semiconductor layer 121 by the support ring 128. The back conductive contact 127 and the stacked conductive layer 131 are disposed within the recess 129. The support ring 128 and recess 129 can be defined using a grinding process (e.g., a TAIKO process) where portions of the semiconductor layer 121 are removed using the grinding process such that the support ring 128 remains.

In some implementations, the first conductive contact 126 can be an emitter contact, the second conductive contact 125 can be a gate contact, and the back conductive contact 127 can be a collector contact.

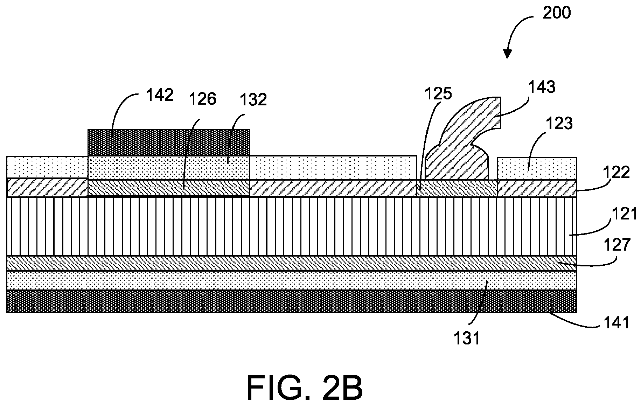

FIG. 2B illustrates the semiconductor device 200, shown in FIG. 2A, after the support ring 128 that was formed by the grinding process has been removed during a cutting process (e.g., a dicing process). In this figure, at the top side of the semiconductor device 200, a solder 142 (e.g., a lead-free solder) is formed over the stacked conductive layer 132 on the first conductive contact 126. A wire bond 143 (e.g., an aluminum wire bond) is coupled to (e.g., joined to, connected to) the conductive contact 125. As shown in FIG. 2B, the wire bond 143 is directly contacted with the second conductive contact 125. On the backside of the semiconductor layer 121, a sinter layer 141 (e.g., a silver (Ag) sinter layer) is applied over the stacked conductive layer 131 disposed on the back conductive contact 127.

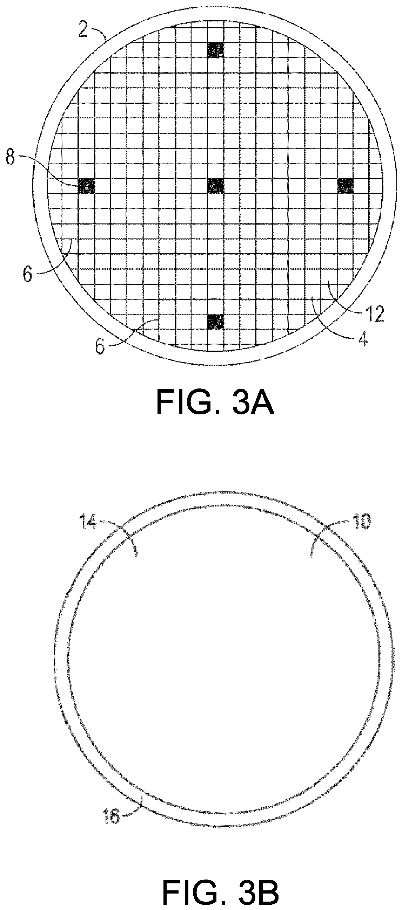

The semiconductor devices 100 and 200 shown in FIGs. 1 through 2B can be formed within a semiconductor wafer. FIGs. 3A and 3B illustrate a semiconductor wafer 2 where the semiconductor devices 100 and 200 shown in FIGs. 1 through 2B can be formed. Specifically, FIG. 3A illustrates a frontside 12 of the semiconductor wafer 2 and FIG. 3B illustrates a backside 10 of the semiconductor wafer 2 shown in FIG. 3A. The semiconductor wafer 2 is not yet singulated in these figures. A number of semiconductor devices 4 (e.g., such as semiconductor devices 100 and 200) are included on the frontside 12 and may include, by non-limiting example, IGBTs or diodes.

Singulation lines 6 show saw streets or the like which will be used to singulate individual semiconductor devices from the wafer 2 using any singulation techniques such as sawing, laser drilling, punching, and so forth. A number of test areas (process control monitors (PCMs)) 8 or otherwise inactive areas may be included on the semiconductor wafer 2-in implementations these may be used to test the operability of the individual semiconductor devices and/or may otherwise be used for handling of the semiconductor wafer 2 during processing (and/or the saw street areas may include test areas).

FIG. 3B shows a recess 14 (similar to recess 129 shown in FIG. 2B) in the backside 10 of the wafer 2 within a support ring 16 (similar to support ring 128 shown in FIG. 2B) of non-removed material. The recess may be formed through backgrinding. The backgrinding leaves the support ring 16 of non-removed material (can also be referred to as a ring) which may help to prevent the semiconductor wafer 2 from curling or otherwise bending during processing but may at the same time thin most of the backside of the semiconductor wafer 2 so that doping may be done through the backside (first side) of the semiconductor wafer 2. In some examples, the support ring 16 may be formed using a TAIKO process. In other implementations of methods of forming semiconductor devices, backgrinding or other material-removal technique may be used (or may be excluded) and/or doping may occur through the frontside instead, eliminating the need for backgrinding or material removal before doping. In some examples, the semiconductor wafer 2 in implementations may be background or otherwise reduced in thickness to as small a size as 75 microns.

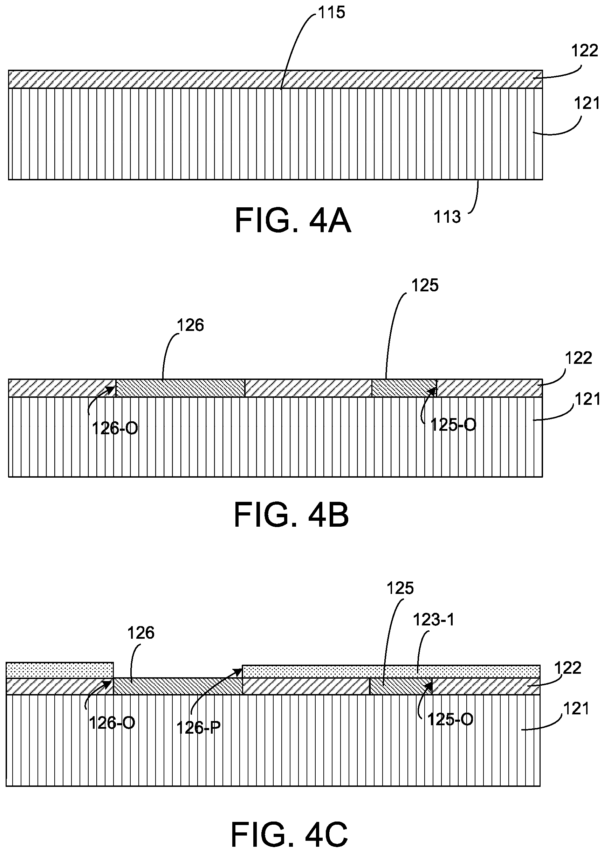

FIGs. 4A through 4K illustrate a method of making the semiconductor devices shown in FIGs. 1 through 3B such as semiconductor device 100 shown in FIG. 1.

FIG. 4A illustrates a semiconductor layer 121 having a frontside 115 and a backside 113 opposite the frontside 115. As shown in FIG. 4A, an insulating layer 122 is formed at the frontside 115 of the semiconductor layer 121.

As shown in FIG. 4B, a first opening 126-0 and a second opening 125-O are formed in the insulating layer 122, and in this implementation a first conductive contact 126 and a second conductive contact 125 are formed in the openings 126-O, 125-O, respectively. The first conductive contact 126 and the second conductive contact 125 are within a same layer as the insulating layer 122. The first conductive contact 126 can be disposed between portions of the insulating layer 122, and the second conductive contact 125 can also be disposed between portions of the insulating layer 122. The first conductive contact 126, the second conductive contact 125, and the insulating layer 122 collectively define a layer over the semiconductor layer 121. In some implementations, the first conductive contact 126 can be an emitter contact, and the second conductive contact 125 can be a gate contact. The first conductive contact 126 can be isolated electrically from the second conductive contact 125 by at least a portion of the insulating layer 122.

In some implementations, the electrically conductive contacts, second conductive contact 125 and the first conductive contact 126, are formed of aluminum. In some examples, the electrically conductive contacts, the second conductive contact 125 and the first conductive contact 126, are formed of evaporated aluminum. In some examples, the electrically conductive contacts, the second conductive contact 125 and the first conductive contact 126, are formed of either AlSi or AlCu, though in other implementations they could be formed of any other electrically conductive materials.

As shown in FIG. 4C, a first polyimide layer 123-1 is disposed (e.g., deposited) on the insulating layer 122 and on the second conductive contact 125 on the frontside 115 of the semiconductor layer 121. As shown in FIG. 4C, the first polyimide layer 123-1 is disposed over (e.g., covers) the second conductive contact 125, but is not disposed over (e.g., does not cover) the first conductive contact 126. Specifically, after the first polyimide layer 123-1 is disposed over the insulating layer 122, the first conductive contact 126, and the second conductive contact 125, an opening 126-P is formed in the first polyimide layer 123-1. Accordingly, the first conductive contact 126 is exposed through the first polyimide layer 123-1. In some implementations, the opening 126-P can have a width or area that corresponds with, or is equal to, an area or width of the first conductive contact 126.

As shown in FIG. 4C, however, an opening is not formed in the first polyimide layer 123-1 over the second conductive contact 125. Accordingly, the first polyimide layer 123-1 continues to cover the second conductive contact 125 so that the second conductive contact 125 is not exposed.

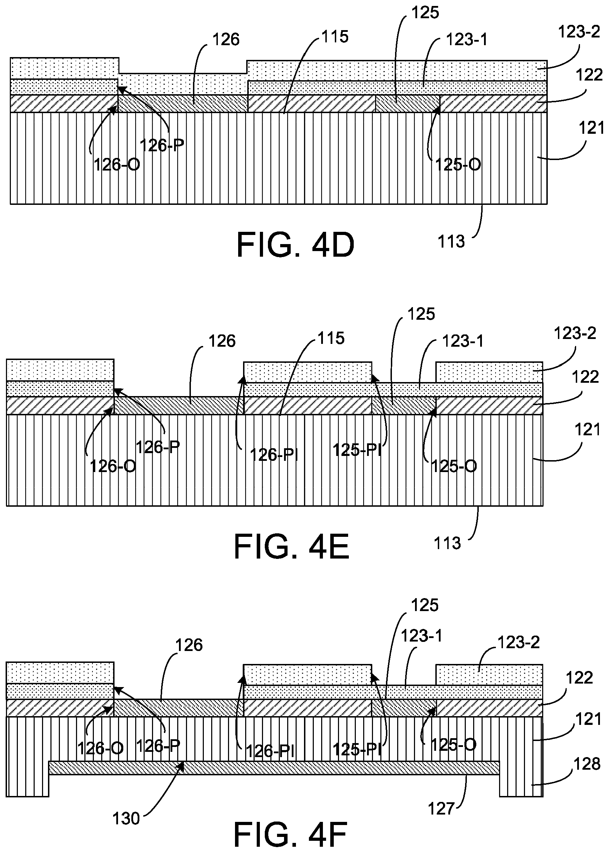

As shown in FIG. 4D, a second polyimide layer 123-2 is deposited above the first polyimide layer 123-1 (on the frontside 115) of the semiconductor layer 121. The second polyimide layer 123-2 covers the first polyimide layer 123-1. The second polyimide layer 123-2 is in contact with the first conductive contact 126 and covers the first conductive contact 126. The second polyimide layer 123-2 is separated from the second conductive contact 125 by the first polyimide layer 123-1.

As shown in FIG. 4E, after the second polyimide layer 123-2 is formed over the first polyimide layer 123-1 at least one opening is formed within the second polyimide layer 123-2. Specifically, in this implementation, two openings-an opening 125-PI and an opening 126-PI-are formed in the second polyimide layer 123-2. The opening 125-PI corresponds with the opening 125-0, but is separated from the second conductive contact 125 by the first polyimide layer 123-1. The first conductive contact 126 is exposed through the first polyimide layer 123-1 and the second polyimide layer 123-2. The second conductive contact 125, however, is not exposed through the first polyimide layer 123-1 and, therefore, not exposed through the opening 125-PI in the second polyimide layer 123-2. The second conductive contact 125 is not exposed through the first polyimide layer 123-1 and is isolated from the opening 125-PI in the second polyimide layer 123-2 by the first polyimide layer 123-1.

As shown in FIG. 4F, a grinding (e.g., a TAIKO grinding) is performed to form a recess 130. In the example shown in FIG. 4F, the recess 130 is a substantially circular recess and is bounded by a support ring 128 of non-removed material (such as shown in FIG. 3B). After formation of the recess, a back conductive contact 127 is disposed in the recess 130.

As described previously, in some examples, the TAIKO process could be excluded and a backgrinding process could be used that backgrinds the entire backside of the wafer (without leaving a ring of non-removed material), or the backgrinding could be excluded altogether.

In some examples, after the TAIKO grinding process, the recess 130 and the inside of the support ring 128 on the backside 113 of the semiconductor layer 121 is etched back. In some examples, the etch back is done in an acidic solution.

In some examples where one or more grinding or material removal processes is performed (e.g., undertaken) at the backside of the wafer, doping may be done into the wafer through the backside of the wafer after the material removal. In some implementations in which the backgrinding or material removal is excluded, the doping may have occurred before the deposition of the contacts and one or more electrically insulating layers and could accordingly be performed (e.g., done) through the frontside of the wafer. In an example, backside of the wafer may be doped, and the dopants may be introduced by any doping technique such as ion implantation, deposition, and diffusion, and the like. One or more dopants such as boron, phosphorous, and so forth may be used (the dopant(s) may be selected depending on the semiconductor substrate such as Si, GaAs, GaN, SiC, and so forth). In some examples, ion implantation is carried out on the backside 113 of the semiconductor layer 121. An annealing process is carried out after the doping, and aluminum is sputtered onto the backside of the semiconductor layer 121 forming the back conductive contact 127. The sputtered aluminum layer may provide a bonding layer between the silicon wafer and a stacked conductive layer (e.g., an ENEPIG layer) that will later be disposed (e.g., deposited) on the backside 113 of the semiconductor layer 121.

In some examples, a second annealing process is performed after sputtering. The second annealing process may help to form a strong bond between the electrically conductive layer and/or may result in desired diffusion of some of the aluminum into the doped region and/or may further distribute/move the dopants in the doped region as desired.

In some examples, the electrically conductive contacts and the electrically insulating layers may be formed using any material deposition and removal techniques such as electro-plating, electroless plating, electrodeposition, spinning, sputtering, evaporation, chemical vapor deposition (CVD), physical vapor deposition (PVD), etching, masking, photolithography techniques, and the like.

In some implementations, the first polyimide layer 123-1 and the second polyimide layer 123-2 are formed (as shown in FIG. 4E) before grinding is performed (as shown in FIG. 4F) because handling of the wafer and/or formation of the first polyimide layer 123-1 and/or the second polyimide layer 123-2 may be difficult or impossible after the grinding is performed.

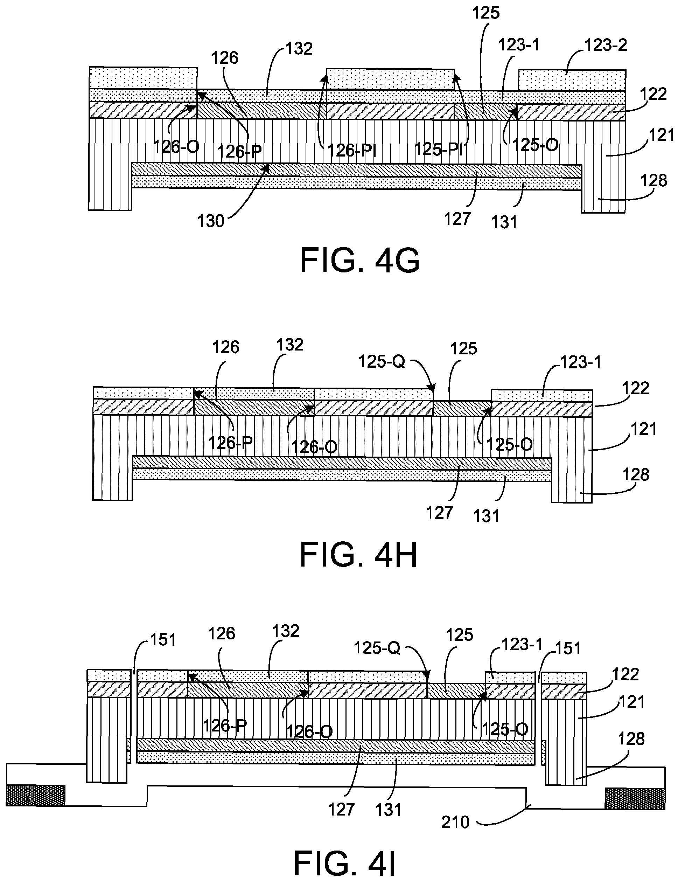

As shown in FIG. 4G, the first conductive contact 126 and the back conductive contact 127 are pretreated for the application of stacked conductive layers 132 and 131 (e.g., an ENEPIG layer). The stacked conductive layer 132 is formed over the first conductive contact 126. The stacked conductive layer 131 is formed over the back conductive contact 127. A stacked conductive layer is not formed over the second conductive contact 125 because the first polyimide layer 123-1 is still disposed on the second conductive contact 125. In other words, a stacked conductive layer is not formed over the second conductive contact 125 because the first polyimide layer 123-1 blocks formation of a stacked conductive layer on the second conductive contact 125. In some examples, the stacked conductive layer may be formed by the deposition of electroless nickel, followed by electroless palladium, with an immersion gold flash.

As shown in FIG. 4H, the first polyimide layer 123-1 over the second conductive contact 125 is etched back, and the second polyimide layer 123-2 is also etched back. The first polyimide layer 123-1 over the second conductive contact 125 is etched back, and the second polyimide layer 123-2 is also etched back after the stacked conductive layer 132 is formed. The first polyimide layer 123-1 over the second conductive contact 125 is etched back to expose the second conductive contact 125 through an opening 125-Q in the first polyimide layer 123-1. The first polyimide layer 123-1 can have a thickness that is the same as (e.g., substantially the same as) a thickness of the second polyimide layer 123-2 so that the second polyimide layer 123-2 is removed, and the second conductive contact 125 through an opening 125-Q in the first polyimide layer 123-1 (using the same etch process). In some implementations, the first polyimide layer 123-1 over the second conductive contact 125 and the second polyimide layer 123-2 are etched back using the same etching process. Thus, the stacked conductive layer 131 over (e.g., disposed over) the back conductive contact 127, the stacked conductive layer 132 over the first conductive contact 126, and the second conductive contact 125 are exposed as shown on FIG. 4H. The stacked conductive layer 132 and the stacked conductive layer 131 collectively define a dual-sided stacked conductive layer device (e.g., a dual-sided ENEPIG layer device).

In some implementations in which the polyimide layer (e.g., first polyimide layer 123-1, second polyimide layer 123-2) is included it may be nine microns, or about nine microns, thick. In some implementations in which one or more polyimide layers are included, the first polyimide layer may be three microns, or about three microns, thick. The second polyimide layer may be seven microns, or about seven microns, thick. The thickness of the polyimide layer is not limited to the thicknesses described above.

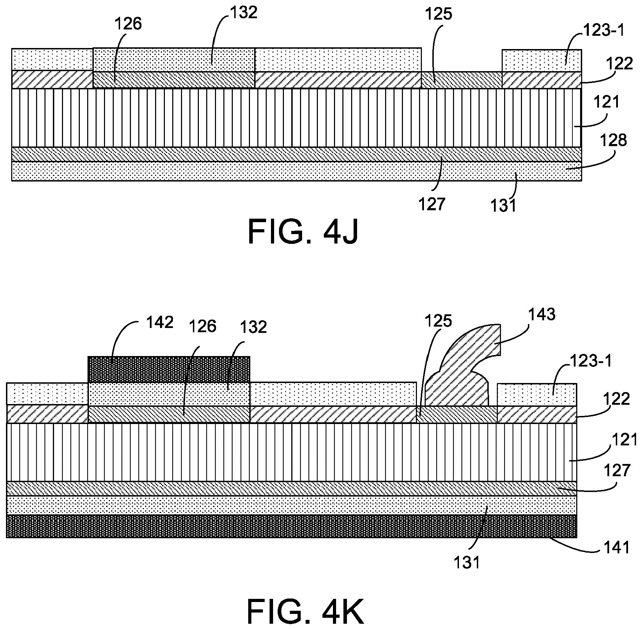

As shown in FIG. 4I, the support ring 128 formed by the backgrinding (such as the TAIKO process) is removed, such as through sawing (e.g., sawing along cuts 151). For protection from external damage from the blade during sawing, an adhesive tape 210 may be attached to the wafer in advance, for wafer singulation. The semiconductor layers that remain may be singulated using any singulation techniques to form the individual semiconductor devices. In some examples, dicing is conducted to obtain the device shown in FIG. 4J.

Referring to FIG. 4K, at the top side (frontside), a solder 142 (e.g., a lead-free solder) is formed over the stacked conductive layer 132 on the conductive contact 126. In this implementation a wire bond 143 (e.g., a metal wire, an Aluminum wire) is connected to the second conductive contact 125 on the backside. In some implementations, at the backside, a sinter layer 141 (e.g., Ag sinter layer) is applied over the stacked conductive layer 131 disposed on the back conductive contact 127.

Any electrically conductive material that bonds well to the semiconductor layer and provides a good bonding for the remainder of the layers, without causing stress issues, may be used as an electrically conductive material for a conductive contact. In some examples, the first conductive contact 126 and the second conductive contact 125 are formed of aluminum, evaporated aluminum, and/or so forth.

After singulation the individual semiconductor devices (such as shown in FIG. 4J) may be included in any package type for final use, such as a leadless package, a leaded package, a molded package, and so forth. In an example, the individual semiconductor devices may be included in a four-lead packaged IGBT, and any of the semiconductor devices formed using any of the processes described herein could be included in a similar package or in a different package type. In some implementations using the stacked conductive layers (e.g., ENEPIG layers) and other layers described herein may increase the reliability of semiconductor devices such as IGBTs and diodes (such as FRDs). The stacked conductive layers and other layers described herein may assist in avoiding oxidation, improving the solderability of copper contacts and plated through-holes, and increasing electrical conductivity.

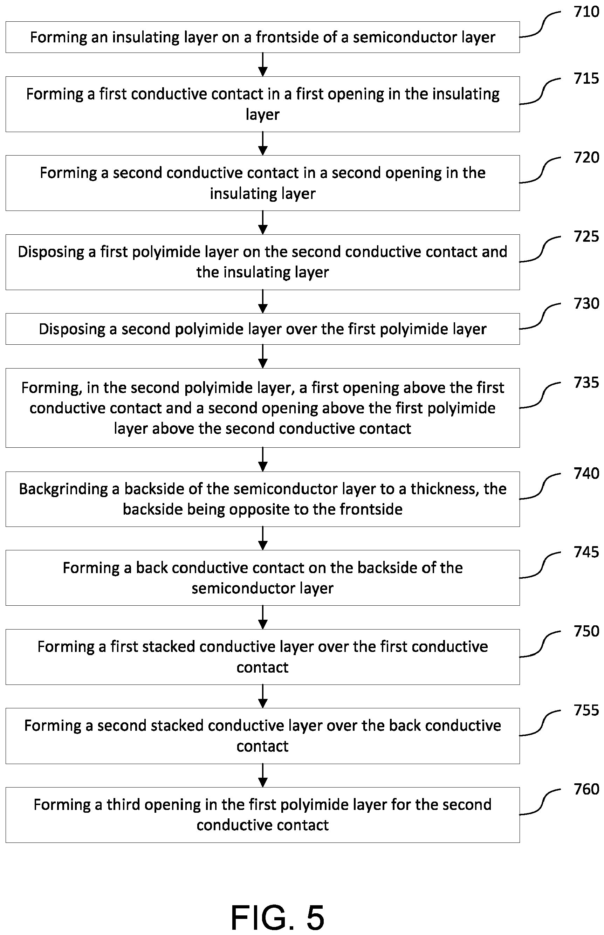

FIG. 5 is a flowchart of an example method of forming semiconductor devices such as those described in connection with FIGS. 1 through 6K. The method can include forming an insulating layer on a frontside of a semiconductor layer (block 710). The method can include forming a first conductive contact in a first opening in the insulating layer (block 715). The method can include forming a second conductive contact in a second opening in the insulating layer (block 720). The method can include forming a first polyimide layer on the second conductive contact and the insulating layer (block 725). The method can include forming a second polyimide layer over the first polyimide layer (block 730). The method can include forming, in the second polyimide layer, a first opening above the first conductive contact and a second opening above the first polyimide layer to expose the first polyimide layer above the second conductive contact through the second opening (block 735). The method can include backgrinding a backside of the semiconductor layer to a thickness, the backside being opposite to the frontside (block 740). The method can include forming a back conductive contact on the backside of the semiconductor layer (block 745). The method can include forming a first stacked conductive layer over the first conductive contact (block 750). The method can include forming a second stacked conductive layer over the back conductive contact (block 755). The method can include forming a third opening in the first polyimide layer for the second conductive contact (block 760).

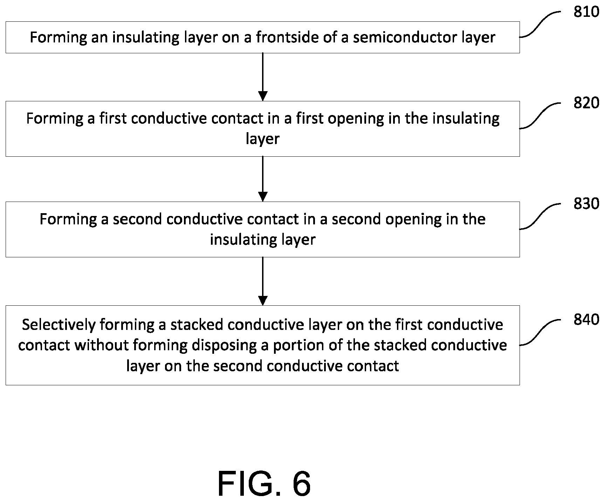

FIG. 6 is a flowchart of an example method of forming semiconductor devices such as those described in connection with FIGS. 1 through 6K. The method can include forming an insulating layer on a frontside of a semiconductor layer (block 810). The method can include forming a first conductive contact in a first opening in the insulating layer (block 820). The method can include forming a second conductive contact in a second opening in the insulating layer (block 830). The method can include selectively forming a stacked conductive layer on the first conductive contact without forming a portion of the stacked conductive layer on the second conductive contact (block 840).

In some aspects, the techniques described herein relate to an apparatus, including: an insulating layer disposed on a frontside of a semiconductor layer; a first conductive contact disposed in a first opening in the insulating layer; a second conductive contact disposed in a second opening in the insulating layer; and a stacked conductive layer disposed on the first conductive contact and excluded from the second conductive contact.

In some aspects, the techniques described herein relate to an apparatus, further including: a polyimide layer disposed on the insulating layer, the stacked conductive layer is disposed in an opening within the polyimide layer.

In some aspects, the techniques described herein relate to an apparatus, wherein the stacked conductive layer is a frontside stacked conductive layer, the apparatus further including: a backside first stacked conductive layer disposed on a backside of the apparatus.

In some aspects, the techniques described herein relate to an apparatus, wherein the polyimide layer is a first polyimide layer, formation of the stacked conductive layer on the second conductive contact is prevented by a second polyimide layer.

In some aspects, the techniques described herein relate to an apparatus, wherein formation of the stacked conductive layer on the second conductive contact is prevented by a polyimide layer.

In some aspects, the techniques described herein relate to an apparatus, further including: a wirebond directly coupled to the second conductive contact.

In some aspects, the techniques described herein relate to an apparatus, further including: a wirebond directly coupled to the second conductive contact through an opening in a polyimide layer.

In some aspects, the techniques described herein relate to an apparatus, wherein the stacked conductive layer includes an Electroless Nickel Electroless Palladium Immersion Gold (ENEPIG) layer.

In some aspects, the techniques described herein relate to a method, including: forming an insulating layer on a frontside of a semiconductor layer; forming a first conductive contact in a first opening in the insulating layer; forming a second conductive contact in a second opening in the insulating layer; and selectively forming a stacked conductive layer on the first conductive contact without forming a portion of the stacked conductive layer on the second conductive contact.

In some aspects, the techniques described herein relate to a method further including: forming a first polyimide layer on the second conductive contact and the insulating layer; forming an opening in the first polyimide layer over the first conductive contact such that the first conductive contact is exposed through the opening in the first polyimide layer; and forming a second polyimide layer over the first polyimide layer and in contact with the first conductive contact through the opening in the first polyimide layer.

In some aspects, the techniques described herein relate to a method, further including: removing a portion of the second polyimide layer such that the first conductive contact is exposed through the first polyimide layer and the second polyimide layer.

In some aspects, the techniques described herein relate to a method, wherein the portion of the second polyimide layer is a first portion of the second polyimide layer, the method further including: removing a second portion of the second polyimide layer to form an opening in the second polyimide layer such that the first polyimide layer is exposed through the opening in the second polyimide layer.

In some aspects, the techniques described herein relate to a method, including: forming an insulating layer on a frontside of a semiconductor layer; forming a first conductive contact in a first opening in the insulating layer; forming a second conductive contact in a second opening in the insulating layer; forming a first polyimide layer on the second conductive contact and the insulating layer; forming a second polyimide layer over the first polyimide layer; forming, in the second polyimide layer, a first opening above the first conductive contact and a second opening above the first polyimide layer to expose the first polyimide layer above the second conductive contact through the second opening; forming a stacked conductive layer over the first conductive contact; and forming a third opening in the first polyimide layer for the second conductive contact.

In some aspects, the techniques described herein relate to a method, wherein the stacked conductive layer is a first stacked conductive layer, the method further including: backgrinding a backside of the semiconductor layer to a thickness, the backside being opposite to the frontside; forming a back conductive contact on the backside of the semiconductor layer; and forming a second stacked conductive layer over the back conductive contact.

In some aspects, the techniques described herein relate to a method, wherein the stacked conductive layer includes an Electroless Nickel Electroless Palladium Immersion Gold (ENEPIG) layer.

In some aspects, the techniques described herein relate to a method, wherein forming of the third opening for the second conductive contact includes etching the first polyimide layer over the second conductive contact while etching the second polyimide layer.

In some aspects, the techniques described herein relate to a method, wherein the backgrinding of the backside of the semiconductor layer includes forming a substantially circular recess in the backside of the semiconductor layer bounded by a support ring of non-removed material.

In some aspects, the techniques described herein relate to a method, further including: forming a solder over the first stacked conductive layer on the first conductive contact; forming a sinter layer over the second stacked conductive layer disposed on the back conductive contact; and coupling a wire bond to the second conductive contact.

In some aspects, the techniques described herein relate to a method, further including implanting at least one dopant into the semiconductor layer through the backside of the semiconductor layer and annealing the semiconductor layer.

In some aspects, the techniques described herein relate to a method, further including forming at least one of an insulated gate bipolar transistors (IGBTs) or a diode in the semiconductor layer.

In some aspects, the techniques described herein relate to a method, wherein the back conductive contact includes evaporated aluminum.

This disclosure, its aspects, and implementations, are not limited to the specific components, assembly procedures or method elements disclosed herein. Many additional components, assembly procedures and/or method elements known in the art consistent with the intended semiconductor BM and OPM structures and related methods will become apparent for use with particular implementations from this disclosure. Accordingly, for example, although particular implementations are disclosed, such implementations and implementing components may comprise any shape, size, style, type, model, version, measurement, concentration, material, quantity, method element, step, and/or the like as is known in the art for such semiconductor BM and OPM structures and related methods, and implementing components and methods, consistent with the intended operation and methods.

It will be understood that, in the foregoing description, when an element is referred to as being on, connected to, electrically connected to, coupled to, or electrically coupled to another element, it may be directly on, connected or coupled to the other element, or one or more intervening elements may be present. When an element is referred to as being directly on, directly connected to or directly coupled to another element, there are no intervening elements present. Although the terms directly on, directly connected to, or directly coupled to may not be used throughout the detailed description, elements that are shown as being directly on, directly connected or directly coupled can be referred to as such. The claims of the application, if any, may be amended to recite exemplary relationships described in the specification or shown in the figures.

As used in this specification, a singular form may, unless definitely indicating a particular case in terms of the context, include a plural form. Spatially relative terms (e.g., over, above, upper, under, beneath, below, lower, and so forth) are intended to encompass different orientations of the device in use or operation in addition to the orientation depicted in the figures. In some implementations, the relative terms above and below can, respectively, include vertically above and vertically below. In some implementations, the term adjacent can include laterally adjacent to or horizontally adjacent to.

Implementations of the various techniques described herein may be implemented in (e.g., included in) digital electronic circuitry, or in computer hardware, firmware, software, or in combinations of them. Some implementations may be implemented using various semiconductor processing and/or packaging techniques. Some implementations may be implemented using various types of semiconductor processing techniques associated with semiconductor substrates including, but not limited to, for example, Si, GaAs, GaN, SiC and/or so forth.

While certain features of the described implementations have been illustrated as described herein, many modifications, substitutions, changes and equivalents will now occur to those skilled in the art. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or sub-combinations of the functions, components and/or features of the different implementations described.

## Claims

1. A method, comprising:
forming an insulating layer on a frontside of a semiconductor layer;
forming a first conductive contact in a first opening in the insulating layer;
forming a second conductive contact in a second opening in the insulating layer; and
selectively forming a stacked conductive layer on the first conductive contact without forming a portion of the stacked conductive layer on the second conductive contact.

2. The method of claim 1 further comprising:
forming a first polyimide layer on the second conductive contact and the insulating layer;
forming an opening in the first polyimide layer over the first conductive contact such that the first conductive contact is exposed through the opening in the first polyimide layer; and
forming a second polyimide layer over the first polyimide layer and in contact with the first conductive contact through the opening in the first polyimide layer.

3. The method of claim 2, further comprising:
removing a portion of the second polyimide layer such that the first conductive contact is exposed through the first polyimide layer and the second polyimide layer.

4. The method of claim 3, wherein the portion of the second polyimide layer is a first portion of the second polyimide layer,
the method further comprising:
removing a second portion of the second polyimide layer to form an opening in the second polyimide layer such that the first polyimide layer is exposed through the opening in the second polyimide layer.

5. An apparatus, comprising:
an insulating layer disposed on a frontside of a semiconductor layer;
a first conductive contact disposed in a first opening in the insulating layer;
a second conductive contact disposed in a second opening in the insulating layer; and
a stacked conductive layer disposed on the first conductive contact and excluded from the second conductive contact.

6. The apparatus of claim 5, further comprising:
a first polyimide layer disposed on the insulating layer, the stacked conductive layer is disposed in an opening within the first polyimide layer, formation of the stacked conductive layer on the second conductive contact is prevented by a second polyimide layer.

7. The apparatus of claim 5, wherein the stacked conductive layer is a frontside stacked conductive layer,
the apparatus further comprising:
a backside first stacked conductive layer disposed on a backside of the apparatus.

8. The apparatus of claim 5, wherein formation of the stacked conductive layer on the second conductive contact is prevented by a polyimide layer.

9. The apparatus of claim 5, further comprising:
a wirebond directly coupled to the second conductive contact through an opening in a polyimide layer.

10. The apparatus of claim 5, wherein the stacked conductive layer includes an Electroless Nickel Electroless Palladium Immersion Gold (ENEPIG) layer.

11. A method, comprising:
forming an insulating layer on a frontside of a semiconductor layer;
forming a first conductive contact in a first opening in the insulating layer;
forming a second conductive contact in a second opening in the insulating layer;
forming a first polyimide layer on the second conductive contact and the insulating layer;
forming a second polyimide layer over the first polyimide layer;
forming, in the second polyimide layer, a first opening above the first conductive contact and a second opening above the first polyimide layer to expose the first polyimide layer above the second conductive contact through the second opening;
forming a stacked conductive layer over the first conductive contact; and
forming a third opening in the first polyimide layer for the second conductive contact.

12. The method of claim 11, wherein the stacked conductive layer is a first stacked conductive layer,
the method further comprising:
backgrinding a backside of the semiconductor layer to a thickness, the backside being opposite the frontside;
forming a back conductive contact on the backside of the semiconductor layer; and
forming a second stacked conductive layer over the back conductive contact.

13. The method of claim 11, wherein forming of the third opening for the second conductive contact includes etching the first polyimide layer over the second conductive contact while etching the second polyimide layer.

14. The method of claim 12, wherein the backgrinding of the backside of the semiconductor layer includes forming a substantially circular recess in the backside of the semiconductor layer bounded by a support ring of non-removed material.

15. The method of claim 12, further comprising:
forming a solder over the first stacked conductive layer on the first conductive contact;
forming a sinter layer over the second stacked conductive layer disposed on the back conductive contact; and
coupling a wire bond to the second conductive contact.
